(19) Europäisches Patentamt
European Patent Office
Office européen des brevets

(11) **EP 1 205 846 A2**

(12) **EUROPÄISCHE PATENTANMELDUNG**

(43) Veröffentlichungstag:
**15.05.2002 Patentblatt 2002/20**

(51) Int Cl.[7]: **G06F 9/45**

(21) Anmeldenummer: **01126342.3**

(22) Anmeldetag: **07.11.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **11.11.2000 DE 10056047**

(71) Anmelder: **ROBERT BOSCH GMBH
70442 Stuttgart (DE)**

(72) Erfinder: **Brachert, Jost
71254 Ditzingen (DE)**

(54) **Verfahren und Vorrichtung zur automatischen Wandlung eines arithmetischen Ausdrucks von Gleitkomma-Arithmetik in Festkomma-Arithmetik**

(57) Die Erfindung betrifft ein Verfahren und eine Vorrichtung zur automatischen Wandlung eines arithmetischen Ausdrucks in Gleitkomma-Arithmetik in einen entsprechenden arithmetischen Ausdruck in Festkomma-Arithmetik. Dabei werden Normierungsfaktoren (c_y, c_t1, c_t2) für eine Normierung von Variablen (y, t1, t2) des Gleitkomma-Ausdrucks bestimmt und die normierten Variablen (Y, T1, T2) in den Gleitkomma-Ausdruck eingesetzt. Um einen Festkomma-Ausdruck mit einem möglichst kompakten Programmcode und einer möglichst kurzen Laufzeit generieren zu können wird vorgeschlagen, dass die Normierungsfaktoren (c_y, c_t1, c_t2) durch Multiplikation und/oder Division so weit zu Konstanten (k1, k2, k) zusammengefasst werden, dass die Anzahl der Konstanten (k1, k2, k) minimiert wird. Es werden außerdem Optimierungsalgorithmen vorgeschlagen, durch die die Anzahl der zur Ausführung des Festkomma-Ausdrucks abzuarbeitenden Operationen weiter reduziert werden kann.

EP 1 205 846 A2

## Beschreibung

Die vorliegende Erfindung betrifft ein Verfahren zur automatischen Wandlung eines arithmetischen Ausdrucks in Gleitkomma-Arithmetik in einen entsprechenden arithmetischen Ausdruck in Festkomma-Arithmetik. Bei dem Verfahren werden Normierungsfaktoren für eine Normierung von Variablen des Gleitkomma-Ausdrucks bestimmt und die normierten Variablen in den Gleitkomma-Ausdruck eingesetzt.

Die Erfindung betrifft außerdem eine Vorrichtung zur automatischen Wandlung eines arithmetischen Ausdrucks in Gleitkomma-Arithmetik in einen entsprechenden arithmetischen Ausdruck in Festkomma-Arithmetik. Die Vorrichtung weist Mittel zum Bestimmen von Normierungsfaktoren für eine Normierung von Variablen des Gleitkomma-Ausdrucks und Mittel zum Einsetzen der normierten Variablen in den Gleitkomma-Ausdruck auf.

Die vorliegende Erfindung betrifft schließlich auch ein Computerprogramm, das auf einem Rechengerät, insbesondere auf einem Mikroprozessor, ablauffähig ist.

Stand der Technik

Bei der Programmierung von Steuergeräten in der Regelungstechnik muss häufig eine Funktion programmiert werden, die durch mathematische Gleichungen bzw. arithmetische Ausdrücke beschrieben ist. Steuergeräte werden bspw. in einem Kraftfahrzeug zur Steuerung und/oder Regelung von verschiedenen Kraftfahrzeugfunktionen (z.B. Antiblockiersystem ABS, Antischlupfregelung ASR, elektronisches Stabilitätsprogramm ESP) eingesetzt. Die zu programmierende Funktion wird aus Kostengründen in der Regel auf einem Rechengerät, insbesondere einem Mikroprozessor, realisiert, das nur ganzzahlige Werte verarbeitet. Das setzt voraus, dass die Gleichungen bzw. Ausdrücke, die für reelle Zahlen mit physikalischen Einheiten gelten, durch eine Normierung auf eine Ganzzahlarithmetik für den Zielprozeossor abgebildet werden. Die Wandlung der arithmetischen Ausdrücke von Gleitkomma-Arithmetik in Festkomma-Arithmetik kann von Hand ausgeführt werden, was jedoch sehr aufwendig ist. Daher gibt es geeignete Software-Werkzeuge (Tools), die einen Programmierer bei diesem Vorgang unterstützen, indem sie die Normierung der arithmetischen Ausdrücke automatisch durchführen. Ein solches Software-Werkzeug ist bspw. das Programm ASCET-SD der Fa. ETAS Entwicklungs- und Applikationswerkzeuge für elektronische Systeme GmbH & Co. KG, Stuttgart, Deutschland.

Das Programm ASCET-SD umfasst einen Codegenerator, der die Normierung der arithmetischen Ausdrücke übernimmt. Er geht dabei wie folgt vor:

Die Syntax von arithmetischen Ausdrücken, d.h. mathematische Ausdrücke, die aus Addition, Subtraktion, Multiplikation und Division bestehen, können durch eine formale Syntaxbeschreibung beschrieben werden. In einer Backus-Naur-Form (BNF) lautet eine Syntaxbeschreibung bspw.:

$$\text{term} :: = \text{term} + \text{term} \tag{1}$$

$$\text{term} :: = \text{term} \{*|/\} \text{term} \tag{2}$$

$$\text{term} :: = v, \tag{3}$$

wobei die Terminale "+", "*" und "/" die arithmetischen Operatoren für eine Gleitkomma-Addition, -Multiplikation bzw. -Division sind und das Terminal "v" für eine beliebige Variable oder Konstante in Gleitkomma-Darstellung steht. Die Subtraktion wird hier nicht gesondert betrachtet, da sie bezüglich der Normierung wie die Addition behandelt werden kann.

Den Gleichungen (1) und (2) entsprechen die nachfolgenden Ausdrücke in Gleitkomma-Arithmetik:

$$y = t1 + t2 \tag{4}$$

$$y = t1 * t2 \tag{5}$$

$$y = t1 / t2 \tag{6}$$

Mit y, t1 und t2 als temporären Zwischenvariablen mit physikalischer Gleitkomma-Darstellung, die das Ergebnis eines "term" der BNF sind.

Zur näheren Erläuterung wird ein Beispiel eingeführt, wobei physikalische Größen durch kleine Buchstaben und ganzzahlige (normierte) Größen durch große Buchstaben bezeichnet sind. Normierungsfaktoren zur Umrechnung von physikalischen Größen in ganzzahlige Größen werden mit c (...) bezeichnet, wobei in den Klammern die Größen angegeben sind, zu deren Normierung sie dienen.

Es wird die Gleichung

$$a = d_1 * s + d_2/t^2 \qquad (B1)$$

betrachtet. Dabei sei a eine Beschleunigung in [m/s$^2$], s eine Strecke in [m] und t eine Zeit in [s] . Als $d_1$ wird ein Paramter in [1/s$^2$] und als $d_2$ ein Parameter in [m] eingeführt. Mit Notierung der Einheiten ergibt sich aus Gleichung (B1):

$$a[m/s^2] = d_1[1/s^2] * s[m] + d_2[m]/(t[s] * t[s]) \qquad (B2).$$

Dabei entsprechen die Unterausdrücken den Gleichungen (4) bis (6) in der Gleitkomma-Arithmetik:

$$d_1 * s + d_2/t^2 = T1 + T2 \qquad (vgl.\ 4)$$

$$d_1 * s = T1 * T2 \qquad (vgl.\ 5)$$

$$d_2/t^2 = T1 / T2 \qquad (vgl.\ 6)$$

Den temporären Zwischenvariablen y, t1 und t2 in Gleitkomma-Arithmetik entsprechen die ganzzahligen Variablen Y, T1 und T2 mit den Normierungsfaktoren c(y), c(t1) und c(t2):

$$Y[inc] = y[unit_y] * c(y)[inc/unit_y] \qquad (7)$$

$$T1[inc] = t1[unit_t1] * c(t1)\ [inc/unit_t1] \qquad (8)$$

$$T2[inc] = t2[unit_t2] * c(t2)\ [inc/unit_t2] \qquad (9)$$

"inc" repräsentiert hierbei die dimensionslose Einheit 1 der ganzzahligen Variablen y, T1 und T2. "unit_y", "unit_t1" und "unit_t2" repräsentieren die physikalischen Einheiten der Variablen Y, t1 und t2. Die Normierungsfaktoren c(y), c (t1) und c(t2) beschreiben die Umrechnung der physikalischen Einheiten in die Ganzzahldarstellung und werden von dem Anwender des Verfahrens (Programmierer) vorgegeben.

Zurückkommend auf das oben eingeführte Beispiel lauten die Normierungsgleichungen:

$$A\ [inc] = a[m/s^2] * c(a)\ [inc/(m/s^2)] \qquad (B3)$$

$$D[inc] = d_1[1/s^2] * c(d1)[inc/(1/s^2)] \qquad (B4)$$

$$S[inc] = s[m] * c\ (s)\ [inc/m] \qquad (B5)$$

$$D_2[inc] = d_2[m] * c(d_2)[inc/m] \qquad (B6)$$

$$T[inc] = t[s] * c(t)\ [inc/s] \quad (B7)$$

Durch Einsetzen der Normierungsgleichungen (7) bis (9) in die Gleichungen (4) bis (6) ergibt sich:

$$\frac{Y}{c(y)} = \frac{T1}{c(t1)} + \frac{T2}{c(t2)} \quad (10)$$

$$\frac{Y}{c(y)} = \frac{T1 * T2}{c(t1) * c(t2)} \quad (11)$$

$$\frac{Y}{c(y)} = \frac{T1 * c(t2)}{T2 * c(t1)} \quad (12)$$

bzw.

$$Y = (\frac{T1}{c(t1)} + \frac{T2}{c(t2)} * c(y) = (T1*m1 + T2*m2) * c(y) \quad (13)$$

$$Y = \frac{T1 * T2}{c(t1) * c(t2)} * c(y) = T1*T2 * m3 * c(y) \quad (14)$$

$$Y = \frac{T1}{T2} * \frac{c(t2)}{c(t1)} * c(y) = T1*m4/T2 * c(y) \quad (15)$$

wobei die Ausdrücke aus den Konstanten c(y), c(t1) und c(t2) zur Compile-Zeit bekannte Ausdrücke sind und der Gleichung (3) der BNF-Syntaxbeschreibung entsprechen. Die Konstanten $m_i$ sind Gleitkommazahlen, die später durch eine Bruchdarstellung aus ganzzahligen Konstanten möglichst genau angenähert werden müssen. Falls y eine temporäre Zwischenvariable darstellt, ist die Einheit von y[inc], d.h. c(y) ist dimensionslos und hat den Wert 1 (vgl. Gleichung (7)).

In dem oben eingeführten Beispiel heißt dies

$$\frac{A}{c(a)} = \frac{D_1 * S}{c(d_1)*c(s)} + \frac{D_2 * c(t)*c(t)}{T*T * c(d_2)} \quad (B8)$$

bzw.

$$A = (\frac{D_1 * S}{c(d_1)*c(s)} + \frac{D_2 * c(t)*c(t)}{T*T * c(d_2)}) * c(a) \qquad (vgl.\ (13)) \quad (B9)$$

wobei die Unterausdrücke T1 und T2 enthalten sind:

$$T1 = \frac{D_1 * S}{c(d_1)*c(s)} c(T1) \quad (B10)$$

$$T2 = \frac{D_2 * c(t) *c(t)}{T*T * c(d_2)} * c(T2) \quad (B11)$$

und

$$A = (\frac{T1}{c(T1)} + \frac{T2}{c(T2)}) * c(a) \quad (B12)$$

Die Normierungsfaktoren $c(d_1)$, c(s), c(t) und $c(d_2)$ werden zu m1 bzw. m2 zusammengefasst:

$$m1 = 1/(c(d_1)*c(s)) \quad \text{(B13)}$$

bzw.

$$m2 = c(t)*c(t)/c(d2) \quad \text{(B14)}$$

so dass

$$A = (D_1*S*m1 + D_2*m2/(T*T)) * c(a) \quad \text{(vgl. (14), (15))} \quad \text{(B15)}$$

Ausgangspunkt für die automatische Normierung ist ein sog. Parsebaum, wie er von einem Compiler nach der Analyse eines zu normierenden arithmetischen Ausdrucks durch einen Parser ausgegeben wird. Der Parsebaum ist so aufgebaut, dass in dem ursprünglichen arithmetischen Ausdruck enthaltene Klammern berücksichtigt und entfernt sind. Den Gleichungen (4) bis (6) entsprechen dabei die folgenden Teilbäume:

```
(16)           (17)           (18)
  \              \              \
  '+'            '*'            '/'
  / \            / \            / \
t1  t2         t1  t2         t1  t2
```

Bei den Teilbäumen kann t1 bzw. t2 entsprechend der Gleichung (3) der BNF-Syntaxbeschreibung auch durch v ersetzt werden. Die Gleitkommadarstellungen t1 bzw. t2 müssen während der automatischen Normierung durch die Ganzzahldarstellungen T1 bzw. T2 mit den zusätzlichen Operationen bzw. Konstanten der Gleichungen (13) bis (15) ersetzt werden. Durch die zusätzlichen Operationen ergeben sich die nachfolgenden Teilbäume:

```
        (19)                  (20)                (21)
          \                     \                   \
          '*'                   '*'                 '*'
         /   \                 /   \               /   \
      '+'    c(y)           '*'    c(y)         '/'    c(y)
      /  \                  /  \                /  \
   '*'    '*'            '*'    m3           '*'    T2
   / \    / \            / \                 / \
 T1  m1  T2  m2        T1  T2              T1  m4
```

Die Multiplikation mit c(y) ist nicht vorhanden, wenn das Ergebnis der angegebenen Teilbäume eine temporäre Zwischenvariable ist. Die Gleitkommakonstanten m1, m2, m3, m4 und c(y) werden mit einem automatischen Algorithmus durch eine Bruchdarstellung mit ganzzahligem Zähler und Nenner ersetzt, die den Wert der Gleitkommakonstanten möglichst gut annähert.

Für das oben eingeführte Beispiel aus Gleichung (B15) ergibt sich der nachfolgende Parsebaum:

```
        (B16) (vgl. (19) bis (21))
          \
          '*'
         /   \
      '+'     c(a)
      /   \
   '*'     '/'
   /  \     /  \
'*'   m1 '*'   '*'
/ \      / \   / \
D1  S   D2 m2 T   T
```

Die Operation "+" fasst die Unterausdrücke T1 und T2 zusammen, die Multiplikationen mit den Normierungskonstanten c(T1) bzw. c(T2) entfallen wie beschrieben, da die Ergebnisse der entsprechenden Teilbäume temporäre Zwischenvariable sind.

Das aus dem Stand der Technik bekannte Verfahren zur Normierung von Gleitkomma-Ausdrücken hat viele überflüssige Operationen zur Folge. Außerdem kann ein Anwender des Verfahrens (Programmierer) die automatische Normierung nicht beeinflussen.

Der vorliegenden Erfindung liegt deshalb die Aufgabe zu Grunde, bei einer automatischen Wandlung eines arithmetischen Ausdrucks von Gleitkomma-Arithmetik in Festkomma-Arithmetik die Anzahl der auf einem Zielprozessor zur Bearbeitung des Festkomma-Ausdrucks auszuführenden Operationen zu reduzieren.

Zur Lösung dieser Aufgabe schlägt die Erfindung ausgehend von dem Verfahren der eingangs genannten Art vor, dass die Normierungsfaktoren von Operanden und einer Ergebnisgröße in allen Teilausdrücken des Gleitkomma-Ausdrucks so weit zu Konstanten zusammengefasst werden, dass die Anzahl der Konstanten minimiert wird.

Vorteile der Erfindung

Erfindungsgemäß wird also vorgeschlagen, die Normierungsfaktoren einschließlich des Normierungsfaktors der Ergebnisgröße zu Konstanten zusammenzufassen, deren Werte ebenfalls schon zur Compile-Zeit bekannt sind und deshalb bereits vor der eigentlichen Normierung berechnet werden können. Im Rahmen der Normierung wird - soweit möglich - nur noch mit den Konstanten und nicht mehr mit den einzelnen Normierungsfaktoren gearbeitet.

Durch das erfindungsgemäße Verfahren kann die Zahl der Operationen, die zur Ausführung des normierten Festkomma-Ausdrucks auf einem Zielprozessor abgearbeitet werden müssen, deutlich reduziert werden. Die Folge ist ein wesentlich kürzeres Steuergeräteprogramm, das wiederum kleinere und billigere Speicherelemente und Mikroprozessoren und/oder einen größeren Funktionsumfang des Steuergeräteprogramms ermöglicht.

Gemäß einer bevorzugten Ausführungsform der vorliegenden Erfindung wird vorgeschlagen, dass bei einer Addition zweier Summanden einerseits der Normierungsfaktor des ersten Summanden und der Normierungsfaktor der Summe zu einer ersten Konstanten zusammengefasst werden, mit der der erste normierte Summand multipliziert wird, und andererseits der Normierungsfaktor des zweiten Summanden und der Normierungsfaktor der Summe zu einer zweiten Konstanten zusammengefasst werden, mit der der zweite normierte Summand multipliziert wird.

Gemäß einer anderen bevorzugten Ausführungsform der Erfindung wird vorgeschlagen, dass bei einer Subtraktion eines Subtrahenden von einem Minuenden einerseits der Normierungsfaktor des Minuenden und der Normierungsfaktor der Differenz zu einer ersten Konstanten zusammengefasst werden, mit der der normierte Minuend multipliziert wird, und andererseits der Normierungsfaktor des Subtrahenden und der Normierungsfaktor der Differenz zu einer zweiten Konstanten zusammengefasst werden, mit der der normierte Subtrahend multipliziert wird.

Gemäß noch einer anderen bevorzugten Ausführungsform der vorliegenden Erfindung wird vorgeschlagen, dass bei einer Multiplikation eines Multiplikanden mit einem Multiplikator der Normierungsfaktor des Multiplikanden, der Normierungsfaktor des Multiplikators und der Normierungsfaktor des Produkts zu einer Konstanten zusammengefasst werden, mit der das Produkt der normierten Faktoren multipliziert wird.

Schließlich wird gemäß einer weiteren bevorzugten Ausführungsform der vorliegenden Erfindung vorgeschlagen, dass bei einer Division eines Dividenden durch einen Divisor der Normierungsfaktor des Dividenden, der Normierungsfaktor des Divisors und der Normierungsfaktor des Quotienten zu einer Konstanten zusammengefasst werden, mit der der Quotient des normierten Dividenden und des normierten Divisors multipliziert wird.

Zusammenfassend werden gemäß dem erfindungsgemäßen Verfahren also auch auch die Normierungsfaktoren der Ausgangsgrößen jedes Teilausdrucks in die Berechnung der Normierungsfaktoren der übrigen Variablen einbezogen. Die Normierungsfaktoren der Variablen, bei denen die Normierungsfaktoren der Ausgangsgrößen berücksichtigt wurden, werden als Konstanten bezeichnet.

Erfindungsgemäß werden des Weiteren verschiedene Optimierungsalgorithmen vorgeschlagen, um die Anzahl der Operationen, die zur Realisierung des Festkomma-Ausdrucks auf dem Zielprozessor ausgeführt werden müssen, weiter zu reduzieren. Als erster Optimierungsalgorithmus wird erfindungsgemäß vorgeschlagen, dass nach dem Zusammenfassen der Normierungsfaktoren die zur Berechnung des Festkomma-Ausdrucks auszuführenden Operationen, die lediglich Multiplikation und Division umfassen, derart umsortiert werden, dass zunächst ein Dividend und ein Divisor durch Multiplikation von Normierungsfaktoren und/oder von normierten Variablen ermittelt wird und anschließend der Dividend durch den Divisor geteilt wird. Der Optimierungsalgorithmus durchsucht den Parsebaum nach Abschnitten, die nur aus Multiplikationen oder Divisionen bestehen. Diese Abschnitte werden derart umsortiert, dass alle Dividenden und alle Divisoren jeweils durch Multiplikation zusammengefasst werden. Die in diesen Abschnitten enthaltenen Divisionen entfallen dabei. Das Produkt der Dividenden wird anschließend durch das Produkt der Divisoren dividiert.

Als ein zweiter Optimierungsalgorithmus wird erfindungsgemäß vorgeschlagen, dass nach dem Zusammenfassen der Normierungsfaktoren bei den zur Berechnung des Festkomma-Ausdrucks auszuführenden Operationen, die lediglich Multiplikation und Division umfassen, die Konstanten zu einer Gesamtkonstanten zusammengefasst werden. Da diese Konstanten zur Compile-Zeit bekannt sind, können sie durch die Gesamtkonstante zusammengefasst und vor der eigentlichen Normierung des Gleitkomma-Ausdrucks berechnet werden.

Vorteilhafterweise werden die Normierungsfaktoren derart gewählt, dass die Konstanten oder die Gesamtkonstante einen einfach zu verarbeitenden Wert aufweist. Die Normierungsfaktoren werden vorzugsweise derart gewählt, dass die Konstanten oder die Gesamtkonstante den Wert einer Zweierpotenz mit einem positiven oder negativen ganzzahligen Exponenten, insbesondere den Wert 1, aufweist.

Der Anwender erhält dadurch die Möglichkeit, durch eine geeignete Wahl der Normierungsfaktoren den von dem Zielprozessor zu verarbeitenden Algorithmus zur Realisierung des Festkomma-Ausdrucks möglichst einfach zu gestalten. Die Multiplikation einer ersten Zahl mit einer zweiten Zahl, deren Wert eine Zweierpotenz mit positivem ganzzahligen Exponenten darstellt, kann auf einem Mikroprozessor sehr einfach ausgeführt werden, indem die Bits (Stellen der Binärdarstellung) der ersten Zahl um den Exponenten der Zweierpotenz der zweiten Zahl in Richtung höherer Wertigkeit verschoben werden. Wenn bspw. eine erste Zahl 5 (101b) mit einer zweiten Zahl $8 = 2^3$ multipliziert werden soll, muss lediglich die erste Zahl 5 = 101b um 3 Bit in Richtung höherer Wertigkeit (d.h. nach links) verschoben werden. Als Produkt ergibt sich 5 * 8 = 101000b = 40.

Eine Multiplikation einer ersten Zahl mit einer zweiten Zahl, deren Wert eine Zweierpotenz mit negativem ganzzahligem Exponenten darstellt (das entspricht einer Division durch den Kehrwert, also durch eine Zweierpotenz mit positivem ganzzahligen Exponenten) kann auf einem Mikroprozessor sehr einfach ausgeführt werden, indem die Bits der ersten Zahl um den negierten Exponenten der Zweierpotenz der zweiten Zahl in Richtung niedrigerer Wertigkeit verschoben werden. Wenn bspw. eine erste Zahl 40 (101000b) mit einer zweiten Zahl $0{,}125 = 2^{-3}$ multipliziert werden soll, entspricht dies einer Division durch 8 = 1/0,125. Die erste Zahl 40 = 101000b wird um 3 Bit in Richtung niedrigerer Wertigkeit (d.h. nach rechts) verschoben, so dass das Ergebnis 40 * 0,125 = 101b = 5 ist. Die Ausführung einer derartigen Verschiebeoperation ("Shift Operation") auf einem Zielprozessor ist im Allgemeinen erheblich schneller als eine entsprechende Multiplikation bzw. Division. Wenn die Gesamtkonstante den Wert 1 aufweist, kann die entsprechende Multiplikation bzw. Division sogar ganz entfallen.

Als ein dritter Optimierungsalgorithmus wird erfindungsgemäß vorgeschlagen, dass die Faktoren des Dividenden und/oder die Faktoren des Divisors durch eine Folge von Multiplikationen und Divisionen derart ersetzt werden, dass ein Verlust an Auflösung der beteiligten Variablen auf das Ergebnis eines betrachteten Teilausdrucks minimiert wird. Dabei wird der von dem Anwender vorzugebende Wertebereich der Variablen betrachtet, so dass die entstehenden Produkte, d.h. das Ergebnis eines betrachteten Teilausdrucks, den Wertbereich der Register des Zielprozessors optimal ausnutzen.

Als ein vierter Optimierungsalgorithmus wird erfindungsgemäß vorgeschlagen, dass für eine jeweils auf eine Multiplikation folgende Division ein Faktor des Divisors mit einem möglichst geringen Wertebereich gewählt wird. Der Wertebereich des Faktors des Divisors wird von dem Anwender vorgegeben. Durch die Wahl eines Faktors des Divisors mit einem möglichst geringen vorgegebenen Wertebereich für eine auf ein Produkt folgende Division, kann der Verlust an Auflösung weiter reduziert werden.

Falls der Verlust an Auflösung dennoch einen vorgebbaren Auflösungsgrenzwert überschreitet, wird vorteilhafterweise aus der Gesamtkonstanten ein Teilfaktor abgespalten, mit dem der ausgewählte Divisorfaktor multipliziert wird. Der Teilfaktor wird vorzugsweise als eine Zweierpotenz mit einem ganzzahligen negativen Exponenten gewählt. Wenn alle Faktoren des Dividenden und des Divisors entsprechend verarbeitet sind, wird der verbleibende Rest der Gesamtkonstante durch eine ganzzahlige Bruchdarstellung, die dem Wert der Gesamtkonstanten möglichst gut angenähert ist, ersetzt.

_Vorteilhafterweise wird der nach dem Abspalten des Teilfaktors verbleibende Teilfaktor durch einen Quotienten aus einem ganzzahligen Zähler und einem ganzzahligen Nenner angenähert.

Als eine weitere Lösung der Aufgabe der vorliegenden Erfindung wird ausgehend von der Vorrichtung der eingangs genannten Art vorgegschlagen, dass die Vorrichtung Mittel zur Ausführung des erfindungsgemäßen Verfahrens aufweist.

Die vorliegende Erfindung betrifft auch ein Computerprogramm, das zur Ausführung des erfindungsgemäßen Verfahrens geeignet ist, wenn es auf einem Rechengerät, insbesondere auf einem Mikroprozessor, abläuft. Besonders bevorzugt ist dabei, wenn das Computerprogramm auf einem Speicherelement, insbesondere auf einem Flash-Memory, abgespeichert ist.

Zeichnungen

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:

Figur 1 ein Ablaufdiagramm eines erfindungsgemäßen Verfahrens gemäß einer bevorzugten Ausführungsform; und

Figur 2 eine erfindungsgemäße Vorrichtung gemäß einer bevorzugten Ausführungsform.

Beschreibung der Ausführungsbeispiele

Das erfindungsgemäße Verfahren wird an Hand des in Figur 1 dargestellten Ablaufdiagramms näher erläutert. Das Verfahren beginnt in einem Funktionsblock 10. In einem Funktionsblock 11 wird zunächst ein arithmetischer Ausdruck in Gleitkomma-Arithmetik nach einem aus dem Stand der Technik bekannten Verfahren in einen entsprechenden arithmetischen Ausdruck in Festkomma-Arithmetik gewandelt. Ein aus dem Stand der Technik bekanntes Verfahren zur Normierung eines Gleitkomma-Ausdrucks ist ausführlich in der Beschreibungseinleitung an Hand eines Beispiels erläutert.

Um die Anzahl der zur Berechnung des Festkomma-Ausdrucks auf einem Zielprozessor auszuführenden Operationen zu minimieren, wird das erfindungsgemäße Verfahren vorgeschlagen. Der in Funktionsblock 11 an Hand des bekannten Verfahrens normierte Festkomma-Ausdruck enthält einige überflüssige Operationen (vgl. den Parsebaum (B16)). Deshalb werden in einem Funktionsblock 12 zunächst die Normierungsfaktoren $c(d_1)$, c(s), $c(d_2)$, c(t) ... und c(a) von Teilausdrücken, die nur aus Multiplikationen und Divisionen bestehen, zu Konstanten k1, k2 zusammengefasst. Es ergibt sich die nachfolgende Gleichung:

$$A = D_1 * S * k1 + D_2/(T * T) * k2 \qquad \text{(B17)}$$

wobei für die Konstanten k1 und k2 gilt:

$$k1 = c(a)/(c(d_1) * c(s)) \qquad \text{(B18)}$$

und

$$k2 = c(a) * c(t) * c(t)/c(d_2) \qquad \text{(B19)}$$

Der Ausdruck A umfasst eine Addition zweier Summanden, was durch die nachfolgende Schreibweise der Gleichung B17 verdeutlicht wird:

$$A = \frac{D_1 * S}{c(d_1) * c(s)} * c(a) + \frac{D_2 * c(t) * c(t)}{T * T * c(d_2)} * c(a) \qquad \text{(B20)}$$

Zur Berechnung der Konstanten k1 und k2 werden einerseits die Normierungsfaktoren $c(d_1)$ und c(s) des ersten Summanden und der Normierungsfaktor c(a) der Summe A zu der ersten Konstanten k1 zusammengefasst.

Andererseits werden die Normierungsfaktoren c(t) und c($d_2$) des zweiten Summanden und der Normierungsfaktor c (a) der Summe A zu der zweiten Konstanten k2 zusammengefasst. Der erste Summand wird mit der Konstanten k1 und der zweite Summand mit der Konstanten k2 multipliziert (vgl. (B17)).

Aus dem Parsebaum (B16) ergibt sich mit den Konstanten k1 und k2 ein erfindungsgemäß optimierter Parsebaum:

```
          (B21)
            \
            '+'
           /   \
        '*'     '*'
       /   \   /   \
    '*'   k1 '/'  k2
    / \       / \
  D1   S    D2  '*'
                / \
               T   T
```

Bei dem optimierten Parsebaum (B21) fällt auf, dass im Gegensatz zu dem Parsebaum (B16) die Multiplikation mit dem Normierungsfaktor c(a) entfällt, da der Normierungsfaktor c(a) bereits in den Konstanten k1 und k2 berücksichtigt ist. Die Konstanten k1 und k2 sind zur Compile-Zeit bekannt und können vor der Ausführung der Operationen zur Berechnung des Festkomma-Ausdrucks A berechnet werden.

Falls nun $D_1$ oder $D_2$ weitere Teilausdrücke bestehend aus einer Summe wären, so würden die Konstanten k1 und k2, da sie die Normierungsfaktoren des Ergebnisses der jeweiligen Teilausdrücke wären, gemäß dem beschriebenen Verfahren wiederum in die Normierungsfaktoren der Summanden der Teilausdrücke einfließen. Der Anwender hat also durch die Vorgabe geeigneter Normierungsfaktoren der Variablen, d.h. sowohl der beteiligten Operanden als auch der Ergebnisgröße, die Möglichkeit in dem automatisch generierten Festkomma-Ausdruck alle auftretenden Normierungskonstanten möglichst einfach zu gestalten.

In einem Funktionsblock 13 wird dann ein erster Optimierungsalgorithmus ausgeführt. Der Optimierungsalgorithmus durchsucht den optimierten Parsebaum (B21) nach Abschnitten, die nur aus Multiplikationen und/oder Divisionen bestehen. Bei dem Parsebaum (B21) sind dies die Abschnitte

```
       (B22)
        /
       '*'
      /   \
    '*'    k1
   /   \
 D1     S
```

und

```
      (B23)
          \
          '*'
         /   \
      '/'     k2
     /    \
   D2     '*'
         /   \
        T     T
```

Der zweite Abschnitt wird derart umsortiert, dass zunächst ein Dividend $D_2$*k2 und ein Divisor T*T durch Multiplikation ermittelt wird. Erst danach wird der Dividend $D_2$*k2 durch den Divisor T*T geteilt. Es ergibt sich der umsortierte Parsebaum wie folgt:

```
      (B24)
          \
          '/'
         /   \
      '*'     '*'
      / \     / \
    D2  k2   T   T
```

Im Rahmen eines zweiten Optimierungsalgorithmus werden in einem Funktionsblock 14 alle Konstanten k1 und k2 in dem Quotienten zusammengefast. Da diese Konstanten zur Compile-Zeit bekannt sind, Können sie durch eine Gesamtkonstante kges zusammengefasst werden mit der der Quotient multipliziert wird. In dem vorliegenden Beispiel ist nicht mehr nöting, da nur jeweils eine dieser Konstanten k1 und k2 in den Abschnitten (Teilbäumen) (B22) und (B24) vorhanden ist. So entspricht die Konstante k1 bzw. die Konstante k2 der Gesamtkonstante kges.

```
        (B25)
          /
         '*'
        /   \
     '*'     kges1
     /  \
   D1    S
```

```
        (B26)
           \
           '/'
          /   \
       '*'     '*'
      /   \    / \
    D2 kges2  T   T
```

Durch die in der Erfindung beschriebene systematik wird insbesondere bei Summen der Normierungsfaktor

der Summe in die Normierungsfaktoren der einzelnen Summanden kges1, kges2 einbezogen. Es findet also eine "Rückwärts-Fortsetzung" des Einflusses des Normierungsfaktors der Ergebnisgröße A in die Normierungsfaktoren der vorhandenen Teilausdrücke kges1, kges2 statt, die ebenfalls wieder Summen enthalten können. Diese "Rückwärts-Fortsetzung" ist insbesondere bei komplizierten Ausdrücken erst durch die hier beschriebene systematische Vorgehensweise realisierbar.

In einem nachfolgenden Funktionsblock 15 wird ein dritter Optimierungsalgorithmus ausgeführt, durch den die Normierungsfaktoren c(a), $c(d_1)$, c(s), $c(d_2)$ und c(t) derart gewählt werden, dass die Gesamtkonstante kges einen einfach zu verarbeitenden Wert aufweist. Ein einfach zu verarbeitender Wert ist bspw. eine Zweierpotenz mit einem positiven oder negativen ganzzahligen Exponenten. Eine besonders einfache Verarbeitung ergibt sich, wenn die Gesamtkonstante kges den Wert 1 aufweist. Durch diesen Optimierungsalgorithmus erhält der Anwender die Möglichkeit, durch eine besondere Wahl der Normierungsfaktoren den von dem Zielprozessor zu verarbeitenden Algorithmus möglichst einfach zu gestalten.

Eine Multiplikation mit einer ersten Zahl a mit einer zweiten Zahl b, deren Wert eine Zweierpotenz mit einem positiven ganzzahligen Exponenten darstellt, kann auf einem Mikroprozessor sehr einfach ausgeführt werden, indem die Bits (Stellen der Binärdarstellung) der Zahl a um den Exponenten der Zweierpotenz der Zahl b in Richtung größerer Wertigkeit (d.h. nach links) verschoben werden. Wenn bspw. die Zahl a = 5 (101b) mit der Zahl b = 8 = $2^3$ multipliziert werden soll, wird die Zahl a = 5 = 101b um drei Bit nach links verschoben, so dass das Ergebnis a * b = 5 * 8 = 101000b = 40 ist.

Eine Multiplikation einer ersten Zahl a mit einer zweiten Zahl b, deren Wert eine Zweierpotenz mit einem negativen ganzzahligen Exponenten darstellt (das entspricht einer Division durch den Kehrwert, also durch eine Zweierpotenz mit positivem ganzzahligen Exponenten) kann auf einem Mikroprozessor sehr einfach ausgeführt werden, indem die Bits der Zahl a um den negierten Exponenten der Zweierpotenz der Zahl b in Richtung niedrigerer Wertigkeit (d.h. nach rechts) verschoben werden. Wenn bspw. die Zahl a = 40 (101000b) mit der Zahl b = 0,125 = $2^{-3}$ multipliziert werden soll, wird die Zahl a = 40 = 101000b um drei Bit nach rechts verschoben, so dass das Ergebnis a * b = 40 * 0,125 = 101b = 5 ist.

Die Ausführung einer derartigen Verschiebeoperation (Shift-Operation) auf einem Mikroprozessor ist im Allgemeinen erheblich schneller als die entsprechende Multiplikation bzw. Division. Wenn die Gesamtkonstante den Wert 1 aufweist, kann die Multiplikation bzw. Division sogar ganz entfallen.

Bei dem oben eingeführten Beispiel wird angenommen, dass die Normierungsfaktoren der Variablen s und t und der Ergebnisvariablen a fest vorgegeben ist:

$$c(a) = 3{,}125\ [inc/(m/s^2)] \qquad (B27)$$

$$c(s) = 100\ [inc/m] \qquad (B28)$$

$$c(t) = 0{,}3\ [inc/s^2] \qquad (B29)$$

Die Normierungsfaktoren der Parameter $d_1$ und $d_2$ können frei gewählt werden. Sie werden im Rahmen des dritten Optimierungsalgorithmus derart gewählt, dass kges1 und kges2 zu 1 werden:
Aus

$$kges1 = c(a)/(c(d_1)*c(s)) \qquad (B30)$$

bzw.

$$kges2 = c(a)*c(t)/c(d_2) \qquad (B31)$$

folgt

$$c(d_1) = c(a)/(c(s)*kges1) \qquad (B32)$$

bzw.

$$c(d_2) = c(a)*c(t)c(t)/kges2 \quad (B33)$$

d.h. eingesetzt

$$c(d_1) = 3{,}125/(100*1) = 0{,}03125\ [inc/(1/s^2)] \quad (B34)$$

bzw.

$$c(d_2) = 3{,}125*0{,}3*0{,}3/1 = 0{,}28125\ [inc/m] \quad (B35)$$

Der betrachtete normierte Ausdruck wird dadurch zu

$$A = D_1*S + D_2/(T*T) \quad (B36)$$

In der Gleichung (B36) tauchen lediglich eine Ganzzahladdition, zwei Ganzzahlmultiplikationen und eine Ganzzahldivision auf, die von einem Mikroprozessor leicht durchgeführt werden können. Falls sich durch die Wahl der Normierungsfaktoren der Parameter $d_1$ und $d_2$ jedoch ungünstige Auflösungen ergeben, müssen sie anders gewählt werden. Gesetzt den Fall, dass die Auflösung von $d_1$ nun gegenüber 0,03125 [inc/(1/s$^2$)] gesteigert werden sollte, würde die Gesamtkonstante kges auf eine entsprechende Zweierpotenz verändert, z.B. 0,125 = $2^{-3}$.

Aus der Gleichung (B32) ergibt sich eingesetzt

$$c(d_1) = 3{,}125/(100*0{,}125) = 0{,}25\ [inc/(1/s^2)] \quad (B37)$$

Der betrachtete normierte Ausdruck wird dadurch zu

$$A = D_1*S*0{,}25 + D_2/(T*T) \quad (B38)$$

Hier taucht gegenüber der Gleichung (B36) noch eine zusätzliche Gleitkommamultiplikation auf.

Schließlich wird in einem Funktionsblock 16 ein vierter Optimierungsalgorithmus ausgeführt. Dabei werden in den Abschnitten (B22) und (B24) des Parsebaums, die lediglich Multiplikation und/oder Division umfassen, die Faktoren des Dividenden und/oder die Faktoren des Divisors durch eine Folge von Multiplikationen und Divisionen ersetzt. Optimierungsziel ist dabei ein möglichst geringer Verlust an Auflösung des Einflusses der beteiligten Variablen auf das Ergebnis eines betrachteten Teilausdrucks. Dabei wird ein vom Anwender vorzugebender Wertebereich der Variablen betrachtet, so dass die entstehenden Produkte den Wertebereich der Register des Zielprozessors optimal ausnutzen.

In dem oben eingeführten Beispiel darf das Produkt $D_1$*S den Wertebereich der Zahlendarstellung des Zielprozessors nicht überschreiten. Der Anwender des Verfahrens muss dazu die Wertebereiche der Variablen vorgeben. Angenommen die Register des verwendeten Mikroprozessors bestehen aus je einem Byte zu jeweils acht Bit, so ist der Wertebereich der Zahlendarstellung in diesem Mikroprozessor 0 bis 255. Weiterhin angenommen, der von dem Anwender vorgegebene physikalische Wertebereich der Variable s wäre 0 bis 0,15 [m] bzw. des Paramters $d_1$ wäre 0 bis 120 [1/s$^2$], d.h. nach den Gleichungen (B28) und (B37) für die normierte ganzzahlige Variable S:0 bis 15 [inc] bzw. für den normierten ganzzahligen Parameter $D_1$:0 bis 30 [inc].

Demnach würde schon bei der Multiplikation von $D_1$ mit S (30 * 15 = 450) der Wertebereich des Zielprozessors überschritten.

Für eine jeweils auf ein Produkt folgende Division wird ein Faktor des Divisors mit einem vom Anwender möglichst geringen vorgegebenen Wertebereich gewählt, um den Verlust an Auflösung gering zu halten. Falls der Verlust an Auflösung trotzdem zu groß ist, wird aus der Gesamtkonstanten kges ein Teilfaktor kges' abgespalten, mit dem der ausgewählte Divisorfaktor multipliziert wird. Der Verlust an Auflösung wird als zu groß erachtet, wenn der Verlust einen vorgebbaren Auflösungsgrenzwert überschreitet. Der abgespaltene Teilfaktor kges' wird vorzugsweise als eine Zweierpotenz mit einem ganzzahligen negativen Exponenten gewählt. Wenn alle Faktoren des Dividendenprodukts und des Divisorprodukts entsprechend verarbeitet sind, wird der verbleibende Rest der Gesamtkonstanten kges durch eine ganzzahlige Bruchdarstellung, die ihren Wert möglichst gut annähert, ersetzt.

Bei dem oben eingeführten Beispiel würde der Optimierungsalgorithmus von der Gesamtkonstanten kges1 den Faktor 0,5 (Zweierpotenz $2^{-1}$) abspalten und $D_1$ vor der Multiplikation mit S mit dieser Zahl multiplizieren (d.h. in einer Shift-Operation um ein Bit nach rechts verschieben), um das Einhalten des Wertebereichs von 0 bis 255 zu gewährleisten. Die Gesamtkonstante kges selbst würde dadurch um diesen Faktor dividiert

$$kges1' = kges1/0,5 = 0,5 \qquad (B40)$$

so dass der entsprechende Ausdruck nun lautet:

$$A = D_1/2 * S * kges1' + D_2/T \qquad (B41)$$

bzw. eingesetzt

$$A = D_1/2 * S * 0,5 + D_2/T \qquad (B42)$$

In einem Funktionsblock 17 ist das erfindungsgemäße Verfahren dann beendet.

In Figur 2 ist eine erfindungsgemäße Vorrichtung zur automatischen Wandlung eines arithmetischen Ausdrucks von Gleitkomma-Arithmetik in Festkomma-Arithmetik in seiner Gesamtheit mit dem Bezugszeichen 20 bezeichnet. Die Vorrichtung 20 wird im Rahmen der Steuergeräteentwicklung zur Programmierung eines Steuergeräts 21 insbesondere eines Kraftfahrzeugs herangezogen. Die Vorrichtung 20 dient insbesondere zur Abbildung eines funktionalen Modells 22 auf ausführbarem Programmcode 23. Die Ziele auf der Ebene einer physikalischen Modellierung 24 und auf der Ebene des Steuergerätes 21 sind verschieden. Von der physikalischen Modellierung 24 wird erwartet, sie sei grafisch, hardwareunabhängig, wiederverwertbar und unterstütze physikalische Datentypen (Gleitkomma-Arithmetik). Auf der Ebene des Steuergeräts 21, d.h. der embeded Softwareimplementierung, sieht das ganz anders aus. Hier wird eine speziell auf den in dem Steuergerät 21 vorliegenden Zielprozessor und die entsprechende Speicheraustattung hin optimierte Codierung erwartet. Codegröße und Laufzeit stehen im Vordergrund. Auch die Datentypen sind in der Regel ganzzahlig (Festpunkt-Arithmetik).

Um eine fehlerträchtige, aufwendige Handcodierung zu vermeiden, wird die erfindungsgemäße Vorrichtung 20 zur automatischen Codegenerierung eingesetzt. Die Vorrichtung 20 umfasst ein Speicherelement 25, insbesondere ein Flash-Memory, auf dem ein Computerprogramm abgespeichert ist. Das Computerprogramm ist auf einem Mikroprozessor 26 der Vorrichtung 20 ablauffähig und zur Ausführung des erfindungsgemäßen Verfahren geeignet.

## Patentansprüche

1. Verfahren zur automatischen Wandlung eines arithmetischen Ausdrucks in Gleitkomma-Arithmetik in einen entsprechenden arithmetischen Ausdruck in Festkomma-Arithmetik, bei dem Normierungsfaktoren (c_y, c_t1, c_t2) für eine Normierung von Variablen (y, t1, t2) des Gleitkomma-Ausdrucks bestimmt werden und die normierten Variablen (Y, T1, T2) in den Gleitkomma-Ausdruck eingesetzt werden, **dadurch gekennzeichnet, dass** die Normierungsfaktoren (c_y, c_t1, c_t2) von Operanden (t1, t2) und einer Ergebnisgröße (y) in allen Teilausdrücken des Gleitkomma-Ausdrucks so weit zu Konstanten (k1, k2, k) zusammengefasst werden, dass die Anzahl der Konstanten (k1, k2, k) minimiert wird.

2. Verfahren nach Anspruch 1, **dadurch gekennzeichnet, dass** bei einer Addition zweier Summanden (t1, t2) einerseits der Normierungsfaktor (c_t1) des ersten Summanden (t1) und der Normierungsfaktor (c_y) der Summe (y) zu einer ersten Konstanten (k1) zusammengefasst werden, mit der der erste normierte Summand (T1) multipliziert wird, und andererseits der Normierungsfaktor (c_t2) des zweiten Summanden (t2) und der Normierungsfaktor (c_y) der Summe (y) zu einer zweiten Konstanten (k2) zusammengefasst werden, mit der der zweite normierte Summand (T2) multipliziert wird.

3. Verfahren nach Anspruch 1, **dadurch gekennzeichnet, dass** bei einer Subtraktion eines Subtrahenden (t2) von einem Minuenden (t1) einerseits der Normierungsfaktor (c_t1) des Minuenden (t1) und der Normierungsfaktor

(c_y) der Differenz (y) zu einer ersten Konstanten (k1) zusammengefasst werden, mit der der normierte Minuend (T1) multipliziert wird, und andererseits der Normierungsfaktor (c_t2) des Subtrahenden (t2) und der Normierungsfaktor (c_y) der Differenz (y) zu einer zweiten Konstanten (k2) zusammengefasst werden, mit der der normierte Subtrahend (T2) multipliziert wird.

**4.** Verfahren nach Anspruch 1, **dadurch gekennzeichnet, dass** bei einer Multiplikation eines Multiplikanden (t1) mit einem Multiplikator (t2) der Normierungsfaktor (c_t1) des Multiplikanden (t1), der Normierungsfaktor (c_t2) des Multiplikators (t2) und der Normierungsfaktor (c_y) des Produkts (y) zu einer Konstanten (k3) zusammengefasst werden, mit der das Produkt der normierten Faktoren (T1, T2) multipliziert wird.

**5.** Verfahren nach Anspruch 1, **dadurch gekennzeichnet, dass** bei einer Division eines Dividenden (t1) durch einen Divisor (t2) der Normierungsfaktor (c_t1) des Dividenden (t1), der Normierungsfaktor (c_t2) des Divisors (t2) und der Normierungsfaktor (c_y) des Quotienten (y) zu einer Konstanten (k4) zusammengefasst werden, mit der der Quotient des normierten Dividenden (T1) und des normierten Divisors (T2) multipliziert wird.

**6.** Verfahren nach einem der Ansprüche 1 bis 5, **dadurch gekennzeichnet, dass** nach dem Zusammenfassen der Normierungsfaktoren (c_y, c_t1, c_t2) die zur Berechnung des Festkomma-Ausdrucks auszuführenden Operationen, die lediglich Multiplikation und Division umfassen, derart umsortiert werden, dass zunächst ein Dividend und ein Divisor durch Multiplikation von Normierungsfaktoren (c_y, c_t1, c_t2) und/oder von normierten Variablen (Y, T1, T2) ermittelt wird und anschließend der Dividend durch den Divisor geteilt wird.

**7.** Verfahren nach einem der Ansprüche 1 bis 6, **dadurch gekennzeichnet, dass** nach dem Zusammenfassen der Normierungsfaktoren (c_y, c_t1, c_t2) bei den zur Berechnung des Festkomma-Ausdrucks auszuführenden Operationen, die lediglich Multiplikation und Division umfassen, die Konstanten (k1, k2, k) zu einer Gesamtkonstanten (kges) zusammengefasst werden.

**8.** Verfahren nach Anspruch 7, **dadurch gekennzeichnet, dass** die Normierungsfaktoren (c_y, c_t1, c_t2) derart gewählt werden, dass die Konstanten (k1, k2, k) oder die Gesamtkonstante (kges) einen einfach zu verarbeitenden Wert aufweist.

**9.** Verfahren nach Anspruch 8, **dadurch gekennzeichnet, dass** die Normierungsfaktoren (c_y, c_t1, c_t2) derart gewählt werden, dass die Konstanten (k1, k2, k) oder die Gesamtkonstante (kges) den Wert einer Zweierpotenz mit einem positiven oder negativen ganzzahligen Exponenten aufweist.

**10.** Verfahren nach Anspruch 9, **dadurch gekennzeichnet, dass** die Normierungsfaktoren (c_y, c_t1, c_t2) derart gewählt werden, dass die Konstanten (k1, k2, k) oder die Gesamtkonstante (kges) den Wert 1 aufweist.

**11.** Verfahren nach einem der Ansprüche 6 bis 10, **dadurch gekennzeichnet, dass** die Faktoren des Dividenden und/ oder die Faktoren des Divisors durch eine Folge von Multiplikationen und Divisionen derart ersetzt werden, dass ein Verlust an Auflösung der beteiligten Variablen (y, t1, t2) auf das Ergebnis eines betrachteten Teilausdrucks minimiert wird.

**12.** Verfahren nach einem der Ansprüche 6 bis 11, **dadurch gekennzeichnet, dass** für eine jeweils auf eine Multiplikation folgende Division ein Faktor des Divisors mit einem möglichst geringen Wertebereich gewählt wird.

**13.** Verfahren nach Anspruch 12, **dadurch gekennzeichnet, dass** aus der Gesamtkonstanten (kges) ein Teilfaktor (kges') abgespalten wird, mit dem der ausgewählte Divisorfaktor multipliziert wird, falls der Verlust an Auflösung einen vorgebbaren Auflösungsgrenzwert überschreitet.

**14.** Verfahren nach Anspruch 13, **dadurch gekennzeichnet, dass** der Teilfaktor (kges') als eine Zweierpotenz mit einem ganzzahligen negativen Exponenten gewählt wird.

**15.** Verfahren nach Anspruch 13, **dadurch gekennzeichnet, dass** der nach dem Abspalten des Teilfaktors (kges') verbleibende Teilfaktor (kges/kges') durch einen Quotienten aus einem ganzzahligen Zähler und einem ganzzahligen Nenner angenähert wird.

**16.** Vorrichtung zur automatischen Wandlung eines arithmetischen Ausdrucks in Gleitkomma-Arithmetik in einen entsprechenden arithmetischen Ausdruck in Festkomma-Arithmetik, wobei die Vorrichtung Mittel zum Bestimmen von

Normierungsfaktoren (c_y, c_t1, c_t2) für eine Normierung von Variablen (y, t1, t2) des Gleitkomma-Ausdrucks und Mittel zum Einsetzen der normierten Variablen (Y, T1, T2) in den Gleitkomma-Ausdruck aufweist, **dadurch gekennzeichnet, dass** die Vorrichtung Mittel zur Ausführung eines Verfahrens nach einem der Ansprüche 1 bis 15 aufweist.

**17.** Computerprogramm, **dadurch gekennzeichnet, dass** das Computerprogramm zur Ausführung eines Verfahrens nach einem der Ansprüche 1 bis 15 geeignet ist, wenn es auf einem Rechengerät, insbesondere auf einem Mikroprozessor, abläuft.

**18.** Computerprogramm nach Anspruch 17, **dadurch gekennzeichnet, dass** das Computerprogramm auf einem Speicherelement, insbesondere auf einem Flash-Memory, abgespeichert ist.

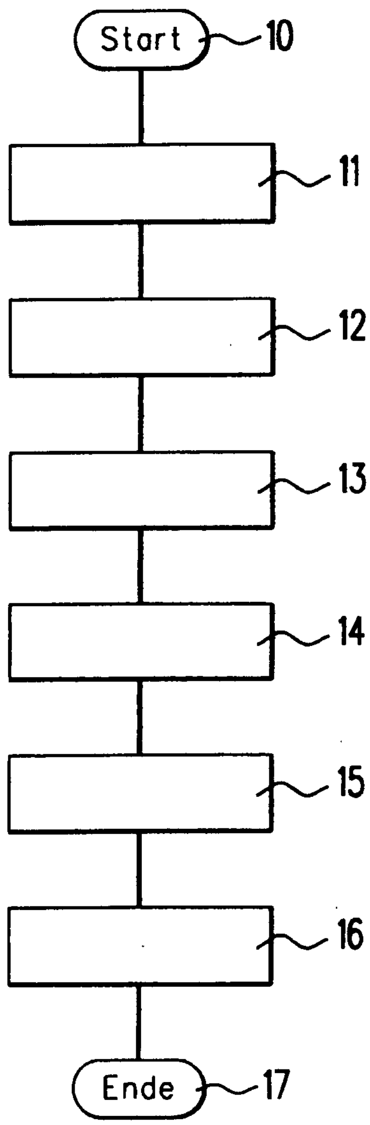


Fig. 1

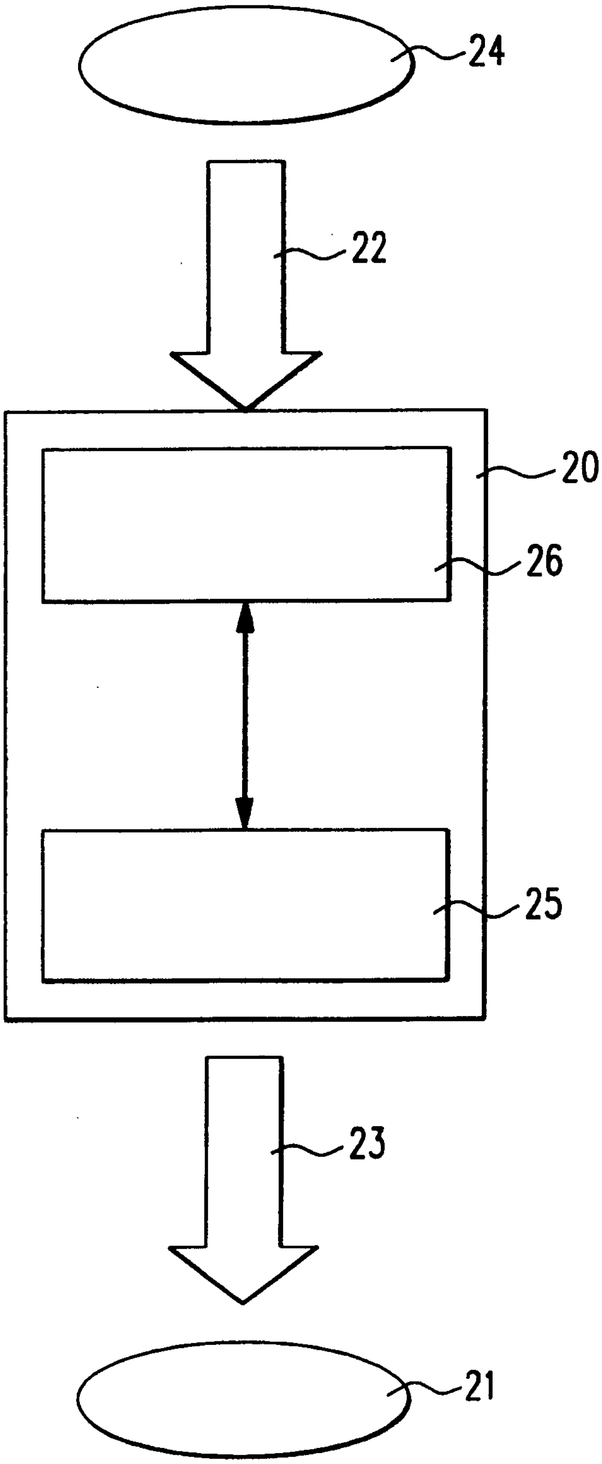


Fig. 2